# EUROPEAN PATENT SPECIFICATION

(11) **EP 3 402 241 B1**
(45) Date of publication and mention of the grant of the patent: **04.08.2021**
(21) Application number: 17170173.3
(22) Date of filing: 09.05.2017
(51) Int. Cl.: H04W 24/10, H04L 12/24, H04L 12/26, H04W 16/22

(54) **SYSTEM SIMULATOR AND SIMULATION METHOD**
SYSTEMSIMULATOR UND SIMULATIONSVERFAHREN
SYSTÈME SIMULATEUR ET PROCÉDÉ DE SIMULATION

(43) Date of publication of application: 14.11.2018
(73) Proprietor: Rohde & Schwarz GmbH & Co. KG, 81671 München (DE)
(72) Inventor: Sterzbach, Bernhard, 81541 München (DE)
(74) Representative: Isarpatent

(56) References cited:
- EP-A2- 1 463 353
- US-A1- 2006 282 247
- US-A1- 2015 318 935
- US-A1- 2017 111 126
- Keysight: "Anite Virtual Drive Testing Toolset", , 14 July 2016 (2016-07-14), XP055406057, Retrieved from the Internet: URL:http://literature.cdn.keysight.com/lit web/pdf/5992-1598EN.pdf?id=2754084 [retrieved on 2017-09-12]
- PAPAZOGLOU P M ET AL: "An Efficient Distributed Event Scheduling Algorithm for Large Scale Wireless Communications Simulation Modelling", SYSTEMS, SIGNALS AND IMAGE PROCESSING, 2009. IWSSIP 2009. 16TH INTERNATIONAL CONFERENCE ON, IEEE, PISCATAWAY, NJ, USA, 18 June 2009 (2009-06-18), pages 1-7, XP031591619, ISBN: 978-1-4244-4530-1

## Description

### TECHNICAL FIELD

The present invention relates to a system simulator. The present invention further relates to a simulation method.

### BACKGROUND

US 2015/318935 A1 discloses a test apparatus and method to perform non-determinative testing of an equipment. A network simulator may emulate base station behaviors according to a known wireless communication standard. Tests may be performed according to predefined test scripts.

EP1463353 A2 relates to testing handover in a mobile communication network. A transmitting/receiving unit transmits a plurality of test signals corresponding to a plurality of cells towards a user equipment, and receives a response signal from the user equipment.

US 2006/0282247 A1 describes a simulator and a method for evaluating embedded wireless communication software including a wireless communication device hardware simulator on which the software is to be embedded and a radio frequency environment simulator. The software is compiled for actual wireless communication device hardware in which the software is to be embedded before testing the compiled software on the simulated wireless communication device hardware in the simulated radio frequency environment.

Although applicable in principal to any communication system, the present invention and its underlying problem will be hereinafter described in combination with wireless communication systems and mobile devices.

In modern communication systems, like e.g. LTE communication systems or future 5G communication systems, a plurality of base stations and the respective cells they span may overlap. A mobile device may e.g. at one point be in reach of tens of base stations.

Since it is not possible or at least very inefficient to simulate such a high number of base stations in parallel, tests of mobile devices are usually performed in real communication environments. Mobile devices may e.g. be installed on a test rig in a vehicle and a test engineer may drive the test rig around in a city to test the device under test with a high number of base stations.

If an error is detected during that test drive, the test engineer will try to reproduce the error in a test laboratory. The basis for such an error reproduction will be the test protocol. Based on the test protocol a test cycle is then derived that may reproduce the error in the mobile device.

However, without simulating all the base stations that where present when the error occurred during the test drive, it is often difficult to reproduce the error in the test laboratory.

Against this background, the problem addressed by the present invention is providing a test system that allows reproducing a communication infrastructure as it may be present under real operating conditions of a mobile device.

### SUMMARY

The present invention solves this objective by a system simulator and a simulation method with the features of the independent claims. Further advantageous embodiments are subject-matter of the dependent claims.

The present invention is based on the finding that a device under test may at the same time only actively receive signals from a limited number of communication partners. Although there may be a plurality of potential communication partners available, the number of actively maintained communications will be limited by the device under test. The number of signals that the device under test may receive from different communication partners may e.g. be determined by the number of transceivers in the device under test. A single transceiver may e.g. be tuned to a specific channel, e.g. a predetermined frequency band, and only communicate via that channel. Communication in this context mainly refers to wireless communication. It is however understood that the interface between the system simulator and the device under test in a test environment may comprise a wired connection. Further, the device under test may also perform a kind of time multiplexing and reconfigure transceivers based on a channel usage schedule. This means that a device under test with a single transceiver may e.g. regularly perform scans for other communication partners with that single transceiver. Such a device may also switch to another communication channel if the channel offers better communication quality. A device under test with a plurality of transceivers may communicate via these transceivers on a plurality of communication channels at the same time and e.g. switch the communication channels from time to time.

A mobile communication device e.g. in a LTE or 5G communication system may for example regularly scan neighboring communication channels for base stations with a better signal quality than the base station that is momentarily used by the device under test. In a LTE system a communication device may e.g. perform a neighboring channel scan every 40 ms for about 6 ms.

The channel usage schedule may beneficially be used in the system simulator to tune or configure respective communication partner simulators to the respective communication channel that is used by the device under test. It is understood, that the communication partner simulators may e.g. comprise communication controllers and transceivers to simulate the respective communication partner for the device under test. It is further understood, that a single communication controller may control a plurality of transceivers. In fact any topology is possible that provides communication with the required number of channels at the same time.

The device under test may theoretically communicate over a massive number of communication channels in modern communication systems, like e.g. LTE or 5G or the like. In LTE networks for example a single communication device may at one moment be in reach of the signals of about 50 base stations or more. However, the number of concurrent communication partners for the device under test will be limited by the number of transceivers in the device under test.

Therefore, with the present invention only the communication partners that are momentarily required to communication with the device under test are simulated. Even with a single communication partner simulator per transceiver in the device under test it is possible to simulate a communication environment for the device under test with a high number of communication partners. It is understood, that the system simulator may e.g. comprise as many communication partner simulators as the device under test comprises transceivers or as the number of channels that the device under test may use concurrently. It is also understood that the device under test may comprise more than that number of communication partner simulators, e.g. one or two more. This allows the control unit to prepare or configure one of the communication partner simulators to use a specific channel already before it is required. Timing constraints for the reconfiguration of a single communication partner simulator will therefore be relaxed. It is understood that an embodiment of a system simulator may comprise a fixed number of communication partner simulators, e.g. 4, 8, 16, 32 or the like and that all of the communication partner simulators may be used independently of the number of transceivers in the device under test.

With the system simulator of the present invention it is therefore possible to simulate a full communication environment for the device under test without actively simulating all possible communication partners permanently and selectively simulating the required communication partners only.

With the system simulator of the present invention it is further possible to use network analysis protocols recorded e.g. during a test drive with a device under test and to reproduce the communication network for the device under test as it existed at a specific place and time.

Further embodiments of the present invention are subject of the further subclaims and of the following description, referring to the drawings.

In a possible embodiment, the system simulator may comprise a usage schedule derivation unit configured to derive the channel usage schedule based on protocol information of a communication protocol that is used by the device under test.

A communication protocol may e.g. impose a channel usage schedule on a device under test. One or more channel usage schedules may e.g. be determined by the communication protocol or the standard that defines the respective communication protocol.

In such a case no active determination of the channel usage schedule by the system simulator is necessary. Instead, the knowledge of the predetermined channel usage schedule(s) may be advantageously used by the control unit to quickly reconfigure the single communication partner simulators as required. If for example it is known that the device under test will be forced by the predetermined channel usage schedule to use a specific channel at a specific time, the control unit may e.g. set a communication partner simulator to communicate via that channel at the required point in time.

The device under test may then e.g. recognize the same communication partner simulator as a new real communication partner, e.g. a new base station.

In a possible embodiment, the system simulator may comprise a test protocol analyzer configured to analyze a test protocol of the device under test and derive the channel usage schedule from the test protocol.

The test protocol may e.g. be recorded during a test drive or the like that is performed with the device under test in a real communication environment, e.g. a city or the like. Such a communication environment provides the test stimulus as it will be perceived by the device under test later under normal operating conditions.

The test protocol may comprise detailed information about the signals that are received by the device under test during the test and the behavior of the device under test. Such behavior may also include the channels that the device under test uses at specific times of the test.

Especially with deterministic devices under test the channel usage schedule may therefore easily be derived from test protocols.

In a possible embodiment, the system simulator may comprise a control algorithm replication unit configured to replicate a control algorithm used in the device under test to control the communication channels used by the device under test to communicate with the communication partners.

The control algorithm replication unit may simulate or replicate the control algorithm that is used in the device under test to select channels for the communication with the communication partners.

It is therefore known in the control algorithm replication unit and therefore also in the system simulator, which channels will be used by the device under test for communication.

The system simulator comprises a channel information interface configured to communicatively couple the control unit to the device under test to retrieve channel usage information from the device under test.

With a channel information interface it is possible to actively retrieve from the device under test the information that is required to determine the channel usage schedule. The system simulator is therefore not limited to guessing the channel usage schedule based on protocol specifications or test protocols.

Instead the system simulator may actively communicate with the device under test via the additional channel information interface and retrieve the required information.

The channel information interface comprises a wiretapping interface configured to tap into the communication between a modem of the device under test and transceivers of the device under test to intercept channel configuration commands from the modem to the transceivers.

The communication between the modem and the transceivers of modern communication devices is usually based on standardized protocols like e.g. CPRI or DigiRF. The wiretapping interface may therefore be adapted to analyze the communication according to the CPRI or DigiRF protocols. It is understood, that the wiretapping interface is not limited to such communication protocols. Instead the wiretapping interface may e.g. also be enabled to receive serial or parallel digital communications from the modem to the transceivers in the device under test. The interface between the modem and the transceivers may also be called IQ-interface. The "modem" may e.g. comprise the software stack and control unit that performs the digital part of transmitting and receiving signals on a protocol level. The transceivers may e.g. comprise the analog devices that are needed to convert the digital data signals into analog RF signals for signal transmission or vice versa for signal reception.

It is understood that the system simulator may e.g. comprise a user interface that allows to configure the details of such serial or parallel data communication and e.g. define the commands that set the channels in the transceivers. Such a configuration option allows flexibly using the system simulator with any type of modem-to-transceiver communication.

The intercepted channel configuration commands may then be analyzed to determine the communication channel that will be used next by the device under test. The control unit may therefore e.g. at the same time as the device under test, reconfigure the respective communication partner simulator and readily provide communication via the newly selected channel.

The device under test will not notice that it is communicating with the same communication partner simulator and accept the communication as originating from a new communication partner.

In a possible embodiment, the channel information interface may comprise a frequency determination interface configured to determine the oscillation frequencies of oscillators in transceivers of the device under test or in a signal emitted by the device under test.

Determining the oscillation frequencies of oscillators in the transceivers allows exactly determining the frequencies that the receiver and transmitter units use for receiving and sending signal. It is therefore possible to determine the transmitting and receiving channel that a transceiver of the device under test uses. This is especially useful in communication systems in which the devices may freely combine receiving and transmitting channels.

If the frequency of the signal emitted by the device under test is analyzed at least the channel that is used by the respective transceiver for transmitting may be determined. Especially in communication systems, where a transmitting channel is coupled to a specific receiving channel this information is enough to determine the receiving and transmitting channels used by the respective transceiver in the device under test.

In a possible embodiment, the channel information interface may comprise a device-side information transmitter that transmits the channel usage information to a simulator-side information receiver.

The device-side information transmitter may e.g. be implemented as a kind of instrumentation of the firmware or software running on the device under test. Such an instrumented firmware may e.g. provide the channel usage information via a data interface to the simulator-side information receiver. Such a data interface may e.g. comprise the wireless communication interface of the device under test. It is however understood that the interface may also be a dedicated data interface provided in the device under test.

The instrumented firmware or software may e.g. provide the channel usage information in advance to the simulator-side information receiver. "In advance" refers to the channel usage information being provided prior to actively controlling the transceivers in the device under test to use the respective channels. This will provide the system simulator with enough time to reconfigure the respective communication partner simulators.

In a possible embodiment, the at least one communication partner simulator may be configured to simulate at least part of the functions of a base station of a communication system that is used by the device under test.

The single communication partner simulators may e.g. each simulate a complete base station of the respective communication system, e.g. a LTE, UMTS or 5G communication system. "At least part of the functions of a base station" refers to the communication partner simulators being capable of simulating at least a subset of functions that are provided by real base stations such that the device under test may be tricked into accepting the respective communication partner simulator as base station.

In an embodiment of the system simulator one of the communication partner simulators may be capable of providing all base station functions needed by the device under test and other communication partner simulators may provide a limited functionality. Such a limited functionality may e.g. be sufficient to simulate a base station to which the device under test is not connected but that may be detected by the device under test. Should the device under test then connect to that base station the communication partner simulator that provides all required functions may be reconfigured to simulate that base station. The communication partner simulator that only provides limited functionality may then be reconfigured to simulate another base station to which the device under test is not connected.

It is understood, that the communication partner simulators, the control unit, the usage schedule derivation unit, the test protocol analyzer, the control algorithm replication unit, the channel information interface, the wiretapping interface, the frequency determination interface, the device-side information transmitter, and the simulator-side information receiver may be provided as hardware, software or firmware or any combination thereof that is required to achieve the respective functionality. Further, the hardware may comprise controllers, programmable logic devices, analog filters, attenuators, amplifiers or the like.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
- Fig. 1: shows a block diagram of an embodiment of a system simulator according to the present invention;
- Fig. 2: shows a block diagram of another embodiment of a system simulator according to the present invention;
- Fig. 3: shows a block diagram of another embodiment of a system simulator according to the present invention;
- Fig. 4: shows a block diagram of another embodiment of a system simulator according to the present invention;
- Fig. 5: shows a block diagram of another embodiment of a system simulator according to the present invention; and
- Fig. 6: shows a flow diagram of an embodiment of a simulation method according to the present invention.

The appended drawings are intended to provide further under-standing of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown to scale.

In the drawings, like, functionally equivalent and identically operating elements, features and components are provided with like reference signs in each case, unless stated other-wise.

### DETAILED DESCRIPTION OF THE DRAWINGS

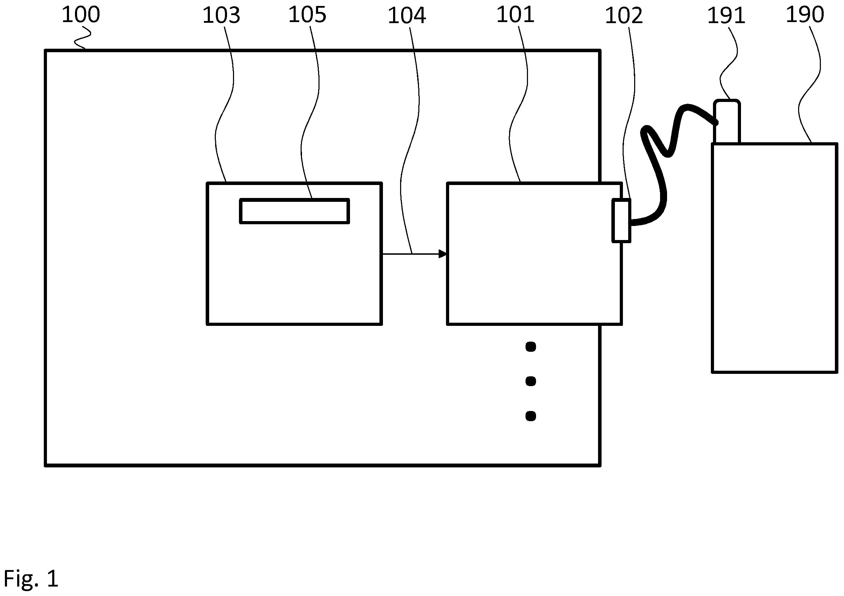

Fig. 1 shows a block diagram of an embodiment of a system simulator 100. The system simulator 100 comprises a communication partner simulator 101. Although only one communication partner simulator 101 is shown, further communication partner simulators are possible and hinted at by three dots. The communication partner simulator 101 is coupled to a communication interface 191 of the device under test 190 via a wired test interface 102. It is understood, that instead of the wired test interface 102 also a wireless test interface may be provided. The system simulator 100 further comprises a control unit 103 that is coupled to the communication partner simulator 101

The control unit 103 comprises a channel usage schedule 105 and controls the communication partner simulator 101 to use specific communication channels 104 based on the channel usage schedule 105. Other possible elements, like e.g. processors, signal generators, timers and the like are omitted for sake of clarity.

The channel usage schedule 105 may comprise information about the type of communication channels 104 that the device under test 190 uses and information about the when the device under test 190 uses the respective communication channels 104. Information about the type of communication channels 104 may e.g. comprise the channel frequency and a bandwidth of the channel, a modulation scheme of the channel and the like.

The channel usage schedule 105 may e.g. be predetermined and stored in the control unit 103. A predetermined channel usage schedule 105 may e.g. be provided by a protocol or communication system specification or the like. The communication system of the device under test 190 may e.g. allow the base stations to provide a channel usage schedule 105 to the device under test 190. Therefore, the channel usage schedule 105 may e.g. be provided to the device under test 190 by the communication partner simulator 101 acting as a base station.

The communication partner simulator 101 may as already indicated simulate a base station of the communication system of the device under test 190. If more than one communication partner simulators 101 are provided at least some of the communication partner simulators 101 may comprise a reduce functionality that e.g. only allows the device under test 190 to discover the respective communication partner simulators 101 as base stations. Should the device under test 190 then switch to such a communication partner simulator 101 with reduced functionality, one of the fully functional communication partner simulators 101 may take over that channel and communicate with the device under test 190.

The system simulator 100 may be used in conjunction with other test devices in a test arrangement. Such a test arrangement may e.g. also comprise test equipment that monitors the reactions of the device under test 190 to specific communication environments that are simulated by the system simulator 100. The test arrangement may also comprise data sources that provide test data that the communication partner simulators 101 may provide to the device under test 190.

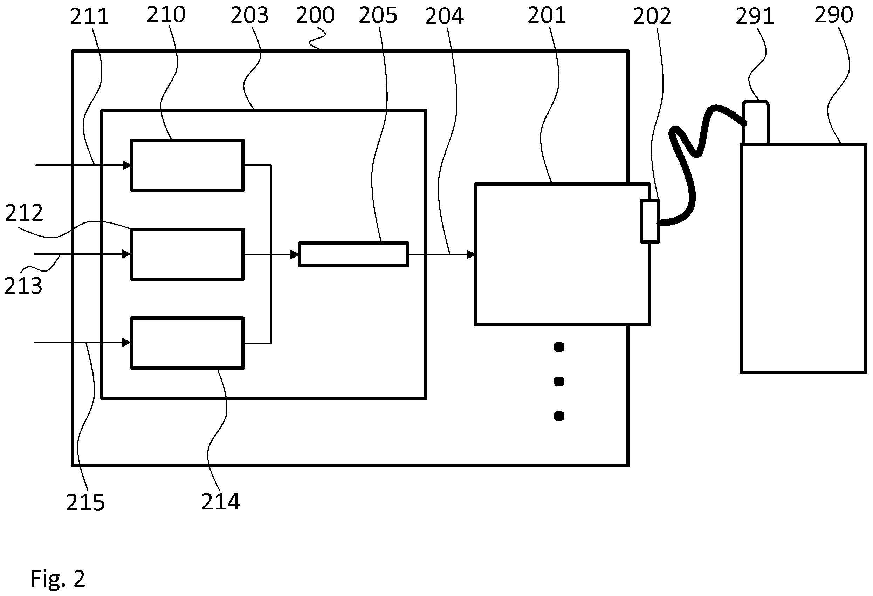

Fig. 2 shows a block diagram of another embodiment of a system simulator 200. In the system simulator 200 three different units are shown that allow determining the channel usage schedule 205 based on different types of input information.

The control unit 203 comprises as a first option a usage schedule derivation unit 210 that derives the channel usage schedule 205 from protocol information 211. The protocol information 211 may e.g. be derived from a protocol specification and may comprise any type of information that may force the device under test 290 to use specific communication channels 204 in a specific order. The protocol information 211 may also comprise a predetermined channel usage schedule 205.

A second option for determining a channel usage schedule 205 is provided by the test protocol analyzer 212. The test protocol analyzer 212 analyzes a test protocol 213 and determines the channel usage schedule 205 based on the test protocol 213. Such a test protocol 213 may be recorded during a test of the device under test 290 in a real communication environment, e.g. while driving in a city. The test protocol may e.g. be provide a table-like, XML-based or text-based result set that may be parsed by a respective parser in the test protocol analyzer 212.

Finally, the system simulator 200 comprises a control algorithm replication unit 214. The control algorithm replication unit 214 may e.g. perform the control algorithm 215 that is used in the device under test 290 in parallel to the device under test 290. This allows the control unit 203 to follow the steps of the device under test 290 and perform corresponding channel changes.

Although all of the three above options are shown in the system simulator 200, it is understood that only one or two of the shown options may be provided in a system simulator 200.

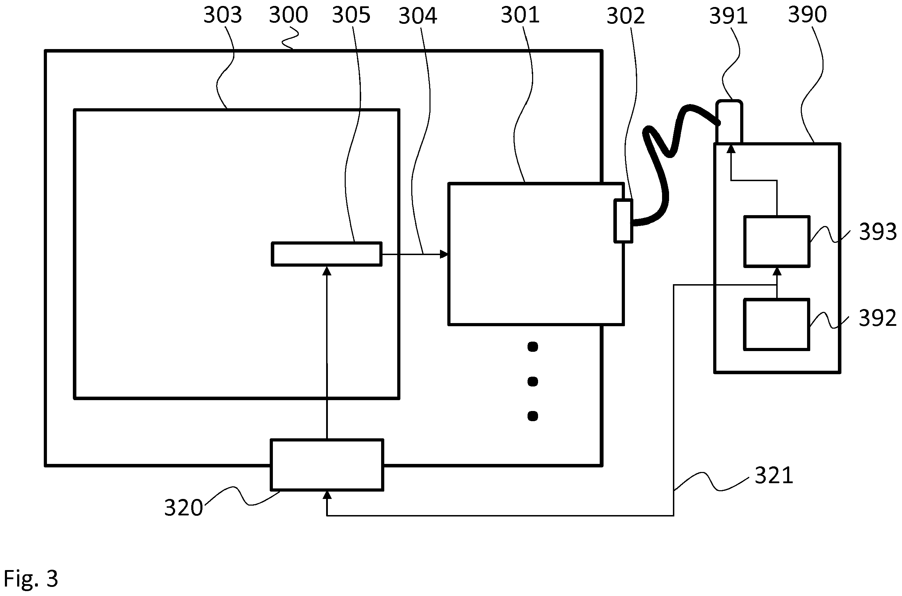

Fig. 3 shows a block diagram of another embodiment of a system simulator 300. The system simulator 300 is based on the system simulator 100. The system simulator 300 therefore comprises a communication partner simulator 301 with a wired test interface 302 and a control unit 303 that controls the communication partner simulator 301 to use specific communication channels 304.

Further, the system simulator 300 comprises a wiretapping interface 320 that is coupled to a communication path between a modem 392 of the device under test 390 and transceivers 393 of the device under test 390. Via the wiretapping interface 320 the control unit 303 may receive channel configuration commands 321 that the modem 392 provides to the receivers 393. With the knowledge of these channel configuration commands 321 the control unit 303 may then determine the communication channels 304, which the communication partner simulator 301 should use next to communication with the device under test 390.

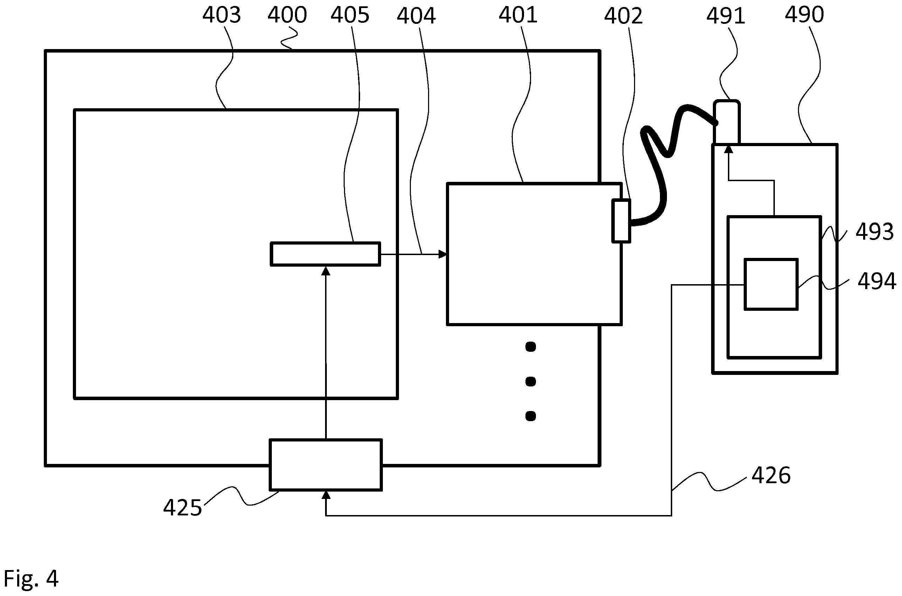

Fig. 4 shows a block diagram of another embodiment of a system simulator 400. The system simulator 400 is also based on the system simulator 100. The system simulator 400 therefore comprises a communication partner simulator 401 with a wired test interface 402 and a control unit 403 that controls the communication partner simulator 401 to use specific communication channels 404. Instead of the wiretapping interface 320, the system simulator 400 comprises a frequency determination interface 425 that determines the oscillation frequencies 426 of oscillators 494 in transceivers 493 of the device under test 490.

With the knowledge of the oscillation frequencies 426 the control unit 403 may then determine the communication channels 404 that the transceivers 493 are currently using to communicate and control the communication partner simulator 401 accordingly.

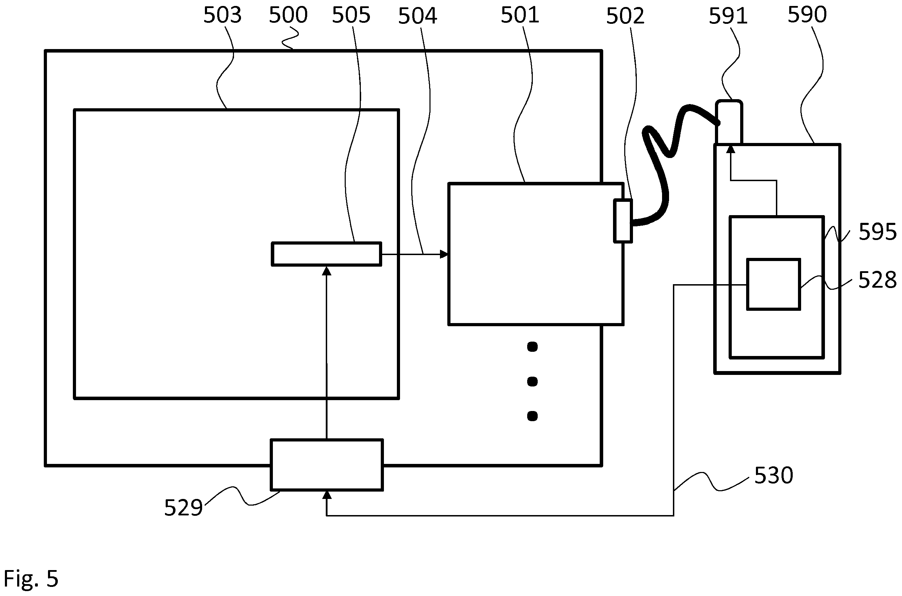

Fig. 5 shows a block diagram of another embodiment of a system simulator 500. The system simulator 500 is also based on the system simulator 100. The system simulator 500 therefore comprises a communication partner simulator 501 with a wired test interface 502 and a control unit 503 that controls the communication partner simulator 501 to use specific communication channels 504. Instead of the wiretapping interface 320 and the frequency determination interface 425, the system simulator 500 comprises two additional units.

In the device under test 590 a controller 595 comprises a device-side information transmitter 528. The device-side information transmitter 528 may e.g. be provided as an instrumented firmware or software that provides the channel usage information 530 to the control unit 503 via a simulator-side information receiver 529.

In Fig. 5 the device-side information transmitter 528 and the simulator-side information receiver 529 are shown as dedicated units in the system simulator 500 and the device under test 590. Any suitable type of data communication may be used to communicate the device-side information transmitter 528 with the simulator-side information receiver 529. For example a dedicated data line or data bus may be provided.

As an alternative, the simulator-side information receiver 529 and the device-side information transmitter 528 may e.g. use the data communication channel that is established via the wired test interface 502 of the communication partner simulator 501 and the communication interface 591 of the device under test 590.

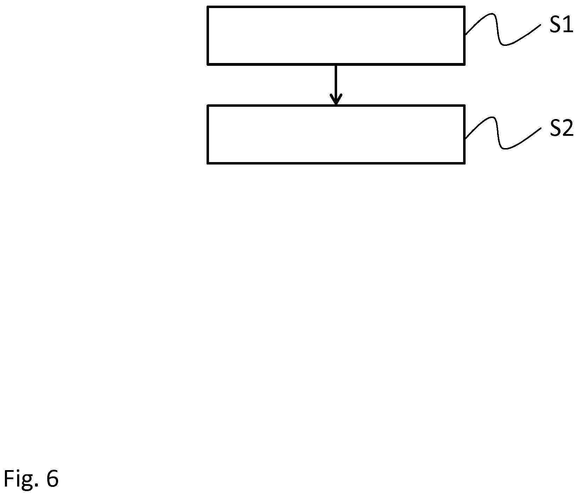

For sake of clarity in the following description of the method based Fig. 6 the reference signs used above in the description of apparatus based Figs. 1 - 5 will be maintained.

Fig. 6 shows a flow diagram of an embodiment of a simulation method for simulating a plurality of communication partners for testing an electronic device under test 190, 290, 390, 490, 590.

The simulation method comprises simulating S1 at least one communication partner of the device under test 190, 290, 390, 490, 590, and dynamically S2 controlling at least the communication channel 104, 204, 304, 404, 504 used by the at least one simulated communication partner based on a channel usage schedule 105, 205, 305, 405, 505 of the device under test 190, 290, 390, 490, 590.

Simulating S1 may comprise simulating at least part of the functions of a base station of a communication system that is used by the device under test 190, 290, 390, 490, 590.

The simulation method may further comprise deriving the channel usage schedule 105, 205, 305, 405, 505 based on protocol information 211 of a communication protocol that is used by the device under test 190, 290, 390, 490, 590.

In addition, the method may comprise analyzing a test protocol 213 of the device under test 190, 290, 390, 490, 590 and deriving the channel usage schedule 105, 205, 305, 405, 505 from the test protocol 213.

Further, the simulation method may comprise replicating a control algorithm 215 used in the device under test 190, 290, 390, 490, 590 to control the communication channels 104, 204, 304, 404, 504 used by the device under test 190, 290, 390, 490, 590 to communicate with the communication partners.

The simulation method may also comprise retrieving channel usage information 530 from the device under test 190, 290, 390, 490, 590. Retrieving the channel usage information 530 may comprise tapping into the communication between a modem 392 of the device under test 190, 290, 390, 490, 590 and transceivers 393, 493 of the device under test 190, 290, 390, 490, 590 and intercepting channel configuration commands 321 from the modem 392 to the transceivers 393, 493. Retrieving the channel usage information 530 may also comprise determining the oscillation frequencies 426 of oscillators 494 in transceivers 393, 493 of the device under test 190, 290, 390, 490, 590 or in a signal emitted by the device under test 190, 290, 390, 490, 590. Retrieving the channel usage information 530 may also comprise transmitting the channel usage information 530 with a device-side information transmitter 528 to a simulator-side information receiver 529.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims. Generally, this application is intended to cover any adaptations or variations of the specific embodiments discussed herein.

In the foregoing detailed description, various features are grouped together in one or more examples or examples for the purpose of streamlining the disclosure. It is understood that the above description is intended to be illustrative, and not restrictive. It is intended to cover all alternatives, modifications and equivalents as may be included within the scope of the invention. Many other examples will be apparent to one skilled in the art upon reviewing the above specification.

Specific nomenclature used in the foregoing specification is used to provide a thorough understanding of the invention. However, it will be apparent to one skilled in the art in light of the specification provided herein that the specific details are not required in order to practice the invention. Thus, the foregoing descriptions of specific embodiments of the present invention are presented for purposes of illustration and description. They are not intended to be exhaustive or to limit the invention to the precise forms disclosed; obviously many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated. Throughout the specification, the terms "including" and "in which" are used as the plain-English equivalents of the respective terms "comprising" and "wherein," respectively. Moreover, the terms "first," "second," and "third," etc., are used merely as labels, and are not intended to impose numerical requirements on or to establish a certain ranking of importance of their objects.

### List of reference signs

- 100, 200, 300, 400, 500: system simulator
- 101, 201, 301, 401, 501: communication partner simulator
- 102, 202, 302, 402, 502: wired test interface
- 103, 203, 303, 403, 503: control unit
- 104, 204, 304, 404, 504: communication channel
- 105, 205, 305, 405, 505: channel usage schedule
- 210: usage schedule derivation unit
- 211: protocol information
- 212: test protocol analyzer
- 213: test protocol
- 214: control algorithm replication unit
- 215: control algorithm
- 320: wiretapping interface
- 321: channel configuration commands
- 425: frequency determination interface
- 426: oscillation frequencies
- 528: device-side information transmitter
- 529: simulator-side information receiver
- 530: channel usage information
- 190, 290, 390, 490, 590: device under test
- 191, 291, 391, 491, 591: communication interface
- 392: modem
- 393, 493: transceiver
- 494: oscillator
- 595: controller
- S1, S2: method steps

## Claims

1. System simulator (100, 200, 300, 400, 500) for a test arrangement for testing an electronic device under test (190, 290, 390, 490, 590) in an environment with a plurality of communication partners, wherein the device under test (190, 290, 390, 490, 590) receives signals from different communication partners, the system simulator (100, 200, 300, 400, 500) comprising:
at least one communication partner simulator (101, 201, 301, 401, 501) configured to simulate a communication partner of the device under test (190, 290, 390, 490, 590), and
a control unit (103, 203, 303, 403, 503) configured to dynamically control at least one communication channel (104, 204, 304, 404, 504) used by the at least one communication partner simulator (101, 201, 301, 401, 501) based on a channel usage schedule (105, 205, 305, 405, 505) of the device under test (190, 290, 390, 490, 590), and
a channel information interface configured to communicatively couple the control unit (103, 203, 303, 403, 503) to the device under test (190, 290, 390, 490, 590) to retrieve channel usage information (530) from the device under test (190, 290, 390, 490, 590),
wherein the channel information interface comprises a wiretapping interface (320) configured to tap into the communication between a modem (392) of the device under test (190, 290, 390, 490, 590) and transceivers (393, 493) of the device under test (190, 290, 390, 490, 590) to intercept channel configuration commands (321) from the modem (392) to the transceivers (393, 493),
wherein the channel usage information (530) is applicable to determine the channel usage schedule (105, 205, 305, 405, 505) of the device under test (190, 290, 390, 490, 590),
wherein the channel usage schedule (105, 205, 305, 405, 505) comprises information about a type of the at least one communication channel (104, 204, 304, 404, 504) that the device under test (190, 290, 390, 490, 590) uses and information about the when the device under test (190, 290, 390, 490, 590) uses the respective communication channels at least one communication channel (104, 204, 304, 404, 504), and
wherein the at least one communication partner simulator (101, 201, 301, 401, 501) is configured to simulate only communication partners out of a plurality of available potential communication partners that are momentarily required to communication with the device under test (190, 290, 390, 490, 590).

2. System simulator (100, 200, 300, 400, 500) according to claim 1, comprising a usage schedule derivation unit (210) configured to derive the channel usage schedule (105, 205, 305, 405, 505) based on protocol information (211) of a communication protocol that is used by the device under test (190, 290, 390, 490, 590), wherein the protocol information (211) comprise a type of information that forces the device under test (190, 290, 390, 490, 590) to use specific communication channels (104, 204, 304, 404, 504) in a specific order.

3. System simulator (100, 200, 300, 400, 500) according to any one of the preceding claims, comprising a test protocol analyzer (212) configured to analyze a test protocol (213) of the device under test (190, 290, 390, 490, 590) and derive the channel usage schedule (105, 205, 305, 405, 505) from the test protocol (213), wherein the test protocol (213) is recorded during a test of the device under test (190, 290, 390, 490, 590) in a real communication environment.

4. System simulator (100, 200, 300, 400, 500) according to any one of the preceding claims, comprising a control algorithm replication unit (214) configured to replicate a control algorithm (215) used in the device under test (190, 290, 390, 490, 590), and the control algorithm replication unit (214) is configured to perform the replicated control algorithm (215) in parallel to the device under test (190, 290, 390, 490, 590) to control the communication channels (104, 204, 304, 404, 504) used by the device under test (190, 290, 390, 490, 590) to communicate with the communication partners.

5. System simulator (100, 200, 300, 400, 500) according to any one of the preceding claims, wherein the channel information interface comprises a frequency determination interface (425) configured to determine the oscillation frequencies (426) of oscillators (494) in transceivers (393, 493) of the device under test (190, 290, 390, 490, 590) or in a signal emitted by the device under test (190, 290, 390, 490, 590).

6. System simulator (100, 200, 300, 400, 500) according to any one of the preceding claims 5, comprising to a simulator-side information receiver (529), wherein the channel information interface comprises a device-side information transmitter (528) communicatively coupled to the simulator-side information receiver (529), the device-side information transmitter (528) being configured to transmit the channel usage information (530) to a simulator-side information receiver (529).

7. System simulator (100, 200, 300, 400, 500) according to any one of the preceding claims, wherein the at least one communication partner simulator (101, 201, 301, 401, 501) is configured to simulate at least part of the functions of a base station of a communication system that is used by the device under test (190, 290, 390, 490, 590).

8. Simulation method for simulating a plurality of communication partners for testing an electronic device under test (190, 290, 390, 490, 590), wherein the device under test (190, 290, 390, 490, 590) receives signals from different communication partners, the simulation method comprising:
simulating (S1) at least one communication partner of the device under test (190, 290, 390, 490, 590),
retrieving channel usage information (530) from the device under test (190, 290, 390, 490, 590), and
dynamically (S2) controlling at least one communication channel (104, 204, 304, 404, 504) used by the at least one simulated communication partner based on a channel usage schedule (105, 205, 305, 405, 505) of the device under test (190, 290, 390, 490, 590),
wherein the channel usage information (530) is applicable to determine the channel usage schedule (105, 205, 305, 405, 505) of the device under test (190, 290, 390, 490, 590),
wherein retrieving channel usage information (530) comprises tapping into the communication between a modem (392) of the device under test (190, 290, 390, 490, 590) and transceivers (393, 493) of the device under test (190, 290, 390, 490, 590) and intercepting channel configuration commands (321) from the modem (392) to the transceivers (393, 493);
wherein the channel usage schedule (105, 205, 305, 405, 505) comprises information about a type of the at least one communication channel (104, 204, 304, 404, 504) that the device under test (190, 290, 390, 490, 590) uses and information about the when the device under test (190, 290, 390, 490, 590) uses the respective communication channels at least one communication channel (104, 204, 304, 404, 504), and
wherein only communication partners out of a plurality of available potential communication partners are simulated that are momentarily required to communication with the device under test (190, 290, 390, 490, 590).

9. Simulation method according to claim 8, comprising deriving the channel usage schedule (105, 205, 305, 405, 505) based on protocol information (211) of a communication protocol that is used by the device under test (190, 290, 390, 490, 590), wherein the protocol information (211) comprise a type of information that forces the device under test (190, 290, 390, 490, 590) to use specific communication channels (104, 204, 304, 404, 504) in a specific order.

10. Simulation method according to claim 8 or 9, comprising analyzing a test protocol (213) of the device under test (190, 290, 390, 490, 590) and deriving the channel usage schedule (105, 205, 305, 405, 505) from the test protocol (213), wherein the test protocol (213) is recorded during a test of the device under test (190, 290, 390, 490, 590) in a real communication environment.

11. Simulation method according to any one of the preceding claims 8 to 10, comprising replicating a control algorithm (215) used in the device under test (190, 290, 390, 490, 590) and performing the replicated control algorithm (215) in parallel to the device under test (190, 290, 390, 490, 590) to control the communication channels (104, 204, 304, 404, 504) used by the device under test (190, 290, 390, 490, 590) to communicate with the communication partners.

12. Simulation method according to any one of claims 8 to 11, wherein retrieving channel usage information (530) comprises determining the oscillation frequencies (426) of oscillators (494) in transceivers (393, 493) of the device under test (190, 290, 390, 490, 590) or in a signal emitted by the device under test (190, 290, 390, 490, 590); and/or
wherein retrieving channel usage information (530) comprises transmitting the channel usage information (530) with a device-side information transmitter (528) to a simulator-side information receiver (529) communicatively coupled to the device-side information transmitter (528).

13. Simulation method according to any one of the preceding claims 8 to 12, wherein simulating comprises simulating at least part of the functions of a base station of a communication system that is used by the device under test (190, 290, 390, 490, 590).

## Patentansprüche

1. Systemsimulator (100, 200, 300, 400, 500) für eine Testanordnung zum Testen einer zu testenden elektronischen Vorrichtung (190, 290, 390, 490, 590) in einer Umgebung mit einer Vielzahl von Kommunikationspartnern, wobei die zu testende Vorrichtung (190, 290, 390, 490, 590) Signale von verschiedenen Kommunikationspartnern empfängt, wobei der Systemsimulator (100, 200, 300, 400, 500) umfasst:
mindestens einen Kommunikationspartnersimulator (101, 201, 301, 401, 501), der für die Simulation eines Kommunikationspartners der zu testenden Vorrichtung (190, 290, 390, 490, 590) konfiguriert ist, und
eine Steuereinheit (103, 203, 303, 403, 503), die für die dynamische Steuerung von mindestens einem Kommunikationskanal (104, 204, 304, 404, 504) konfiguriert ist, der von dem mindestens einem Kommunikationspartnersimulator (101, 201, 301, 401, 501) verwendet wird, auf der Grundlage eines Zeitplans (105, 205, 305, 405, 505) für die Kanalnutzung der zu testenden Vorrichtung (190, 290, 390, 490, 590), und
eine Kanalinformationsschnittstelle, die dafür konfiguriert ist, die Steuereinheit (103, 203, 303, 403, 503) mit der zu testenden Vorrichtung (190, 290, 390, 490, 590) kommunikativ zu koppeln, um Kanalnutzungsinformationen (530) von der zu testenden Vorrichtung (190, 290, 390, 490, 590) abzurufen,
wobei die Kanalinformationsschnittstelle eine Abhörschnittstelle (320) umfasst, die dafür konfiguriert ist, die Kommunikation zwischen einem Modem (392) der zu testenden Vorrichtung (190, 290, 390, 490, 590) und Transceivern (393, 493) der zu testenden Vorrichtung (190, 290, 390, 490, 590) abzuhören, um Befehle (321) zur Kanalkonfiguration von dem Modem (392) zu den Transceivern (393, 493) abzuhören,
wobei die Kanalnutzungsinformationen (530) zur Bestimmung des Zeitplans (105, 205, 305, 405, 505) für die Kanalnutzung der zu testenden Vorrichtung (190, 290, 390, 490, 590) angewendet werden können,
wobei der Zeitplan (105, 205, 305, 405, 505) für die Kanalnutzung Informationen über einen Typ des mindestens einen Kommunikationskanals (104, 204, 304, 404, 504), den die zu testende Vorrichtung (190, 290, 390, 490, 590) nutzt, und, Informationen darüber, wann die zu testende Vorrichtung (190, 290, 390, 490, 590) die jeweiligen Kommunikationskanäle nutzt, mindestens einen Kommunikationskanal (104, 204, 304, 404, 504), umfasst, und
wobei der mindestens ein Kommunikationspartnersimulator (101, 201, 301, 401, 501) dafür konfiguriert ist, nur Kommunikationspartner aus einer Vielzahl verfügbarer potenzieller Kommunikationspartner zu simulieren, die momentan für die Kommunikation mit der zu testenden Vorrichtung (190, 290, 390, 490, 590) erforderlich sind.

2. Systemsimulator (100, 200, 300, 400, 500) nach Anspruch 1, umfassend eine Nutzungszeitplan-Ableitungseinheit (210), die dafür konfiguriert ist, den Zeitplan (105, 205, 305, 405, 505) für die Kanalnutzung auf der Grundlage von Protokollinformationen (211) eines Kommunikationsprotokolls abzuleiten, das von der zu testenden Vorrichtung (190, 290, 390, 490, 590) verwendet wird, wobei die Protokollinformationen (211) einen Typ von Informationen umfassen, der die zu testende Vorrichtung (190, 290, 390, 490, 590) dazu zwingt, bestimmte Kommunikationskanäle (104, 204, 304, 404, 504) in einer bestimmten Reihenfolge zu nutzen.

3. Systemsimulator (100, 200, 300, 400, 500) nach einem der vorstehenden Ansprüche, umfassend einen Testprotokollanalysator (212), der dafür konfiguriert ist, ein Testprotokoll (213) der zu testenden Vorrichtung (190, 290, 390, 490, 590) zu analysieren und den Zeitplan (105, 205, 305, 405, 505) für die Kanalnutzung aus dem Testprotokoll (213) abzuleiten, wobei das Testprotokoll (213) während eines Tests der zu testenden Vorrichtung (190, 290, 390, 490, 590) in einer realen Kommunikationsumgebung aufgezeichnet wird.

4. Systemsimulator (100, 200, 300, 400, 500) nach einem der vorstehenden Ansprüche, umfassend eine Replikationseinheit (214) für einen Regelalgorithmus, die zur Replikation eines Regelalgorithmus (215) konfiguriert ist, der in der zu testenden Vorrichtung (190, 290, 390, 490, 590) verwendet wird, und wobei die Replikationseinheit (214) für einen Regelalgorithmus dafür konfiguriert ist, den replizierten Regelalgorithmus (215) parallel zu der zu testenden Vorrichtung (190, 290, 390, 490, 590) auszuführen, um die Kommunikationskanäle (104, 204, 304, 404, 504) zu regeln, die von der zu testenden Vorrichtung (190, 290, 390, 490, 590) für die Kommunikation mit den Kommunikationspartnern genutzt werden.

5. Systemsimulator (100, 200, 300, 400, 500) nach einem der vorstehenden Ansprüche, wobei die Kanalinformationsschnittstelle eine Frequenzbestimmungsschnittstelle (425) umfasst, die zur Bestimmung der Schwingungsfrequenzen (426) der Oszillatoren (494) in den Transceivern (393, 493) der zu testenden Vorrichtung (190, 290, 390, 490, 590) oder in einem Signal, das von der zu testenden Vorrichtung (190, 290, 390, 490, 590) ausgegeben wird, konfiguriert ist.

6. Systemsimulator (100, 200, 300, 400, 500) nach einem der vorstehenden Ansprüche, umfassend einen simulatorseitigen Informationsempfänger (529), wobei die Kanalinformationsschnittstelle einen geräteseitigen Informationssender (528) umfasst, der mit dem simulatorseitigen Informationsempfänger (529) kommunikativ gekoppelt ist, wobei der geräteseitige Informationssender (528) für die Übertragung der Kanalnutzungsinformationen (530) an einen simulatorseitigen Informationsempfänger (529) konfiguriert ist.

7. Systemsimulator (100, 200, 300, 400, 500) nach einem der vorstehenden Ansprüche, wobei der mindestens eine Kommunikationspartnersimulator (101, 201, 301, 401, 501) dafür konfiguriert ist, mindestens einen Teil der Funktionen einer Basisstation eines Kommunikationssystems zu simulieren, das von der zu testenden Vorrichtung (190, 290, 390, 490, 590) genutzt wird.

8. Simulationsverfahren zur Simulation einer Vielzahl von Kommunikationspartnern zum Testen einer zu testenden elektronischen Vorrichtung (190, 290, 390, 490, 590), wobei die zu testende Vorrichtung (190, 290, 390, 490, 590) Signale von verschiedenen Kommunikationspartnern empfängt, wobei das Simulationsverfahren umfasst:
Simulieren (S1) mindestens eines Kommunikationspartners der zu testenden Vorrichtung (190, 290, 390, 490, 590),
Abrufen von Kanalnutzungsinformationen (530) von der zu testenden Vorrichtung (190, 290, 390, 490, 590), und
dynamisches Steuern (S2) von mindestens einem Kommunikationskanal (104, 204, 304, 404, 504), der von dem mindestens einem simulierten Kommunikationspartner (101, 201, 301, 401, 501) genutzt wird, auf der Grundlage eines Zeitplans (105, 205, 305, 405, 505) für die Kanalnutzung der zu testenden Vorrichtung (190, 290, 390, 490, 590),
wobei die Kanalnutzungsinformationen (530) zur Bestimmung des Zeitplans (105, 205, 305, 405, 505) für die Kanalnutzung der zu testenden Vorrichtung (190, 290, 390, 490, 590) angewendet werden kann,
wobei das Abrufen der Kanalnutzungsinformationen (530) das Abhören der Kommunikation zwischen einem Modem (392) der zu testenden Vorrichtung (190, 290, 390, 490, 590) und Transceivern (393, 493) der zu testenden Vorrichtung (190, 290, 390, 490, 590) und das Abhören der Befehle (321) zur Kanalkonfiguration von dem Modem (392) an die Transceiver (393, 493) umfasst;
wobei der Zeitplan (105, 205, 305, 405, 505) für die Kanalnutzung Informationen über einen Typ des mindestens einen Kommunikationskanals (104, 204, 304, 404, 504), den die zu testende Vorrichtung (190, 290, 390, 490, 590) nutzt, und, Informationen darüber, wann die zu testende Vorrichtung (190, 290, 390, 490, 590) die jeweiligen Kommunikationskanäle nutzt, mindestens einen Kommunikationskanal (104, 204, 304, 404, 504), umfasst, und
wobei nur Kommunikationspartner aus einer Vielzahl verfügbarer potenzieller Kommunikationspartner simuliert werden, die momentan für die Kommunikation mit der zu testenden Vorrichtung (190, 290, 390, 490, 590) erforderlich sind.

9. Simulationsverfahren nach Anspruch 8, umfassend das Ableiten eines Zeitplans (105, 205, 305, 405, 505) für die Kanalnutzung auf der Grundlage von Protokollinformationen (211) eines Kommunikationsprotokolls, das von der zu testenden Vorrichtung (190, 290, 390, 490, 590) verwendet wird, wobei die Protokollinformationen (211) einen Typ von Informationen umfassen, der die zu testende Vorrichtung (190, 290, 390, 490, 590) dazu zwingt, bestimmte Kommunikationskanäle (104, 204, 304, 404, 504) in einer bestimmten Reihenfolge zu nutzen.

10. Simulationsverfahren nach Anspruch 8 oder 9, umfassend das Analysieren eines Testprotokolls (213) der zu testenden Vorrichtung (190, 290, 390, 490, 590) und Ableiten des Zeitplans (105, 205, 305, 405, 505) für die Kanalnutzung aus dem Testprotokoll (213), wobei das Testprotokoll (213) während eines Tests der zu testenden Vorrichtung (190, 290, 390, 490, 590) in einer realen Kommunikationsumgebung aufgezeichnet wird.

11. Simulationsverfahren nach einem der vorstehenden Ansprüche 8 bis 10, umfassend das Replizieren eines Regelalgorithmus (215), der in der zu testenden Vorrichtung (190, 290, 390, 490, 590) verwendet wird, und das Ausführen des replizierten Regelalgorithmus (215) parallel zu der zu testenden Vorrichtung (190, 290, 390, 490, 590), um die Kommunikationskanäle (104, 204, 304, 404, 504) zu regeln, die von der zu testenden Vorrichtung (190, 290, 390, 490, 590) zur Kommunikation mit den Kommunikationspartnern genutzt werden.

12. Simulationsverfahren nach einem der Ansprüche 8 bis 11, wobei das Abrufen von Kanalnutzungsinformationen (530) das Bestimmen der Schwingungsfrequenzen (426) der Oszillatoren (494) in den Transceivern (393, 493) der zu testenden Vorrichtung (190, 290, 390, 490, 590) oder in einem Signal, das von der zu testenden Vorrichtung (190, 290, 390, 490, 590) ausgegeben wird, umfasst; und/oder
wobei das Abrufen der Kanalnutzungsinformationen (530) das Übertragen der Kanalnutzungsinformationen (530) mit einem geräteseitigen Informationssender (528) zu einem simulatorseitigen Informationsempfänger (529) umfasst, der mit dem geräteseitigen Informationssender (528) kommunikativ gekoppelt ist.

13. Simulationsverfahren nach einem der vorstehenden Ansprüche 8 bis 12, wobei das Simulieren das Simulieren mindestens eines Teils der Funktionen einer Basisstation eines Kommunikationssystems umfasst, das von der zu testenden Vorrichtung (190, 290, 390, 490, 590) genutzt wird.

## Revendications

1. Simulateur de système (100, 200, 300, 400, 500) pour un agencement de test pour tester un dispositif électronique à l'essai (190, 290, 390, 490, 590) dans un environnement avec une pluralité de partenaires de communication, dans lequel le dispositif à l'essai (190, 290, 390, 490, 590) reçoit des signaux à partir de différents partenaires de communication, le simulateur de système (100, 200, 300, 400, 500) comprenant :
au moins un simulateur de partenaire de communication (101, 201, 301, 401, 501) configuré pour simuler un partenaire de communication du dispositif à l'essai (190, 290, 390, 490, 590), et
une unité de commande (103, 203, 303, 403, 503) configurée pour commander dynamiquement au moins un canal de communication (104, 204, 304, 404, 504) utilisé par le au moins un simulateur de partenaire de communication (101, 201, 301, 401, 501) sur la base d'un programme d'utilisation de canal (105, 205, 305, 405, 505) du dispositif à l'essai (190, 290, 390, 490, 590), et
une interface d'informations de canal configurée pour coupler de manière communicative l'unité de commande (103, 203, 303, 403, 503) au dispositif à l'essai (190, 290, 390, 490, 590) pour récupérer des informations d'utilisation de canal (530) à partir du dispositif à l'essai (190, 290, 390, 490, 590),
dans lequel l'interface d'informations de canal comprend une interface de mise sur écoute (320) configurée pour écouter la communication entre un modem (392) du dispositif à l'essai (190, 290, 390, 490, 590) et des émetteurs-récepteurs (393, 493) du dispositif à l'essai (190, 290, 390, 490, 590) pour intercepter des instructions de configuration de canal (321), du modem (392) aux émetteurs-récepteurs (393, 493),
dans lequel les informations d'utilisation de canal (530) sont applicables pour déterminer le programme d'utilisation de canal (105, 205, 305, 405, 505) du dispositif à l'essai (190, 290, 390, 490, 590),
dans lequel le programme d'utilisation de canal (105, 205, 305, 405, 505) comprend des informations sur un type du au moins un canal de communication (104, 204, 304, 404, 504) que le dispositif à l'essai (190, 290, 390, 490, 590) utilise et des informations sur le moment où le dispositif à l'essai (190, 290, 390, 490, 590) utilise les canaux de communication respectifs au moins un canal de communication (104, 204, 304, 404, 504), et
dans lequel le au moins un simulateur de partenaire de communication (101, 201, 301, 401, 501) est configuré pour simuler uniquement des partenaires de communication parmi une pluralité de partenaires de communication potentiels disponibles qui sont momentanément requis pour communiquer avec le dispositif à l'essai (190, 290, 390, 490, 590).

2. Simulateur de système (100, 200, 300, 400, 500) selon la revendication 1, comprenant une unité de dérivation de programme d'utilisation (210) configurée pour dériver le programme d'utilisation de canal (105, 205, 305, 405, 505) sur la base d'informations de protocole (211) d'un protocole de communication qui est utilisé par le dispositif à l'essai (190, 290, 390, 490, 590), dans lequel les informations de protocole (211) comprennent un type d'informations qui forcent le dispositif à l'essai (190, 290, 390, 490, 590) à utiliser des canaux de communication spécifiques (104, 204, 304, 404, 504) dans un ordre spécifique.

3. Simulateur de système (100, 200, 300, 400, 500) selon l'une quelconque des revendications précédentes, comprenant un analyseur de protocole de test (212) configuré pour analyser un protocole de test (213) du dispositif à l'essai (190, 290, 390, 490, 590) et dériver le programme d'utilisation de canal (105, 205, 305, 405, 505) à partir du protocole de test (213), dans lequel le protocole de test (213) est enregistré pendant un test du dispositif à l'essai (190, 290, 390, 490, 590) dans un environnement de communication réel.

4. Simulateur de système (100, 200, 300, 400, 500) selon l'une quelconque des revendications précédentes, comprenant une unité de réplication d'algorithme de commande (214) configurée pour répliquer un algorithme de commande (215) utilisé dans le dispositif à l'essai (190, 290, 390, 490, 590), et l'unité de réplication d'algorithme de commande (214) est configurée pour réaliser l'algorithme de commande répliqué (215) en parallèle du dispositif à l'essai (190, 290, 390, 490, 590) pour commander le canal de communications (104, 204, 304, 404, 504) utilisé par le dispositif à l'essai (190, 290, 390, 490, 590) pour communiquer avec les partenaires de communication.

5. Simulateur de système (100, 200, 300, 400, 500) selon l'une quelconque des revendications précédentes, dans lequel l'interface d'informations de canal comprend une interface de détermination de fréquence (425) configurée pour déterminer les fréquences d'oscillation (426) d'oscillateurs (494) dans des émetteurs-récepteurs (393, 493) du dispositif à l'essai (190, 290, 390, 490, 590) ou dans un signal émis par le dispositif à l'essai (190, 290, 390, 490, 590).

6. Simulateur de système (100, 200, 300, 400, 500) selon l'une quelconque des revendications précédentes, comprenant un récepteur d'informations côté simulateur (529), dans lequel l'interface d'informations de canal comprend un émetteur d'informations côté dispositif (528) couplé de manière communicative au récepteur d'informations côté simulateur (529), l'émetteur d'informations côté dispositif (528) étant configuré pour transmettre les informations d'utilisation de canal (530) à un récepteur d'informations côté simulateur (529).

7. Simulateur de système (100, 200, 300, 400, 500) selon l'une quelconque des revendications précédentes, dans lequel le au moins un simulateur de partenaire de communication (101, 201, 301, 401, 501) est configuré pour simuler au moins une partie des fonctions d'une station de base d'un système de communication qui est utilisé par le dispositif à l'essai (190, 290, 390, 490, 590).

8. Procédé de simulation pour simuler une pluralité de partenaires de communication pour tester un dispositif électronique à l'essai (190, 290, 390, 490, 590), dans lequel le dispositif à l'essai (190, 290, 390, 490, 590) reçoit des signaux à partir de différents partenaires de communication, le procédé de simulation comprenant :
la simulation (S1) d'au moins un partenaire de communication du dispositif à l'essai (190, 290, 390, 490, 590),
la récupération des informations d'utilisation de canal (530) à partir du dispositif à l'essai (190, 290, 390, 490, 590), et
la commande dynamique (S2) d'au moins un canal de communication (104, 204, 304, 404, 504) utilisé par le au moins un partenaire de communication simulé sur la base d'un programme d'utilisation de canal (105, 205, 305, 405, 505) du dispositif à l'essai (190, 290, 390, 490, 590),
dans lequel les informations d'utilisation de canal (530) sont applicables pour déterminer le programme d'utilisation de canal (105, 205, 305, 405, 505) du dispositif à l'essai (190, 290, 390, 490, 590),
dans lequel la récupération des informations d'utilisation de canal (530) comprend l'écoute de la communication entre un modem (392) du dispositif à l'essai (190, 290, 390, 490, 590) et des émetteurs-récepteurs (393, 493) du dispositif à l'essai (190, 290, 390, 490, 590) et l'interception d'instructions de configuration de canal (321), du modem (392) aux émetteurs-récepteurs (393, 493) ;
dans lequel le programme d'utilisation de canal (105, 205, 305, 405, 505) comprend des informations sur un type du au moins un canal de communication (104, 204, 304, 404, 504) que le dispositif à l'essai (190, 290, 390, 490, 590) utilise, et des informations sur le moment où le dispositif à l'essai (190, 290, 390, 490, 590) utilise les canaux de communication respectifs au moins un canal de communication (104, 204, 304, 404, 504), et
dans lequel seuls des partenaires de communication parmi une pluralité de partenaires de communication potentiels disponibles sont simulés et sont momentanément requis pour communiquer avec le dispositif à l'essai (190, 290, 390, 490, 590) .

9. Procédé de simulation selon la revendication 8, comprenant la dérivation du programme d'utilisation de canal (105, 205, 305, 405, 505) sur la base d'informations de protocole (211) d'un protocole de communication qui est utilisé par le dispositif à l'essai (190, 290, 390, 490, 590), dans lequel les informations de protocole (211) comprennent un type d'informations qui forcent le dispositif à l'essai (190, 290, 390, 490, 590) à utiliser des canaux de communication spécifiques (104, 204, 304, 404, 504) dans un ordre spécifique.

10. Procédé de simulation selon la revendication 8 ou 9, comprenant l'analyse d'un protocole de test (213) du dispositif à l'essai (190, 290, 390, 490, 590) et la dérivation du programme d'utilisation de canal (105, 205, 305, 405, 505) à partir du protocole de test (213), dans lequel le protocole de test (213) est enregistré pendant un test du dispositif à l'essai (190, 290, 390, 490, 590) dans un environnement de communication réel.

11. Procédé de simulation selon l'une quelconque des revendications précédentes 8 à 10, comprenant la réplication d'un algorithme de commande (215) utilisé dans le dispositif à l'essai (190, 290, 390, 490, 590) et la réalisation de l'algorithme de commande répliqué (215) en parallèle au dispositif à l'essai (190, 290, 390, 490, 590) pour commander le canal de communications (104, 204, 304, 404, 504) utilisé par le dispositif à l'essai (190, 290, 390, 15 490, 590) pour communiquer avec les partenaires de communication.

12. Procédé de simulation selon l'une quelconque des revendications 8 à 11, dans lequel la récupération d'informations d'utilisation de canal (530) comprend la détermination des fréquences d'oscillation (426) d'oscillateurs (494) dans des émetteurs-récepteurs (393, 493) du dispositif à l'essai (190, 290, 390, 490, 590) ou dans un signal émis par le dispositif à l'essai (190, 290, 390, 490, 590) ; et/ou
dans lequel la récupération d'informations d'utilisation de canal (530) comprend la transmission des informations d'utilisation de canal (530) avec un émetteur d'informations côté dispositif (528) à un récepteur d'informations côté simulateur (529) couplé de manière communicative à l'émetteur d'informations côté dispositif (528).

13. Procédé de simulation selon l'une quelconque des revendications précédentes 8 à 12, dans lequel la simulation comprend la simulation d'au moins une partie des fonctions d'une station de base d'un système de communication qui est utilisé par le dispositif à l'essai (190, 290, 390, 490, 590).
